# EUROPEAN PATENT APPLICATION

(11) **EP 1 324 401 A1**
(43) Date of publication of application: **02.07.2003**
(21) Application number: 01970233.1
(22) Date of filing: 26.09.2001
(51) Int. Cl.: H01L 41/08

(54) **DIELECTRIC THIN FILM ELEMENT, ACTUATOR COMPRISING IT, INK JET HEAD, AND INK JET RECORDER.**

(30) Priority: 27.09.2000 JP 2000293803
(71) Applicant: MATSUSHITA ELECTRIC INDUSTRIAL CO., LTD., Kadoma-shi, Osaka 571-8501 (JP)
(72) Inventor: KAMADA, Takeshi, Nara-shi, Nara 631-0027 (JP); TORII, Hideo, Higashiosaka-shi, Osaka 578-0976 (JP); TAKAYAMA, Ryoichi, Suita-shi, Osaka 564-0081 (JP)
(74) Representative: Stippl, Hubert, Dipl.-Ing.
(86) International application number: JP0108402
(87) International publication number: WO02027809

(57) **Abstract**

A dielectric thin film element enables controlling of a crystal orientation of a dielectric thin film and optimization of a variety of characteristics such as electric characteristics. This dielectric thin film element (10) comprises a substrate (11), a first electrode (12) formed on the substrate (11), a dielectric thin film (13) formed on the first electrode (12) and a second electrode (14) formed on the dielectric thin film (13) and is fabricated with the substrate (11) being heated. A material having a predetermined thermal expansion coefficient is used as the material of the substrate (11), and a crystal orientation of the dielectric thin film (13) is controlled by the thermal expansion coefficient of the substrate (11).

## Description

### TECHNICAL FIELD

The present invention relates to a dielectric thin film element that is used for piezoelectric elements, pyroelectric infrared detecting elements, nonvolatile memories, electro-optic effect elements or the like, and an actuator utilizing the piezoelectric effect of a piezoelectric dielectric, an ink jet head using the same and an ink jet recording apparatus provided with the ink jet head.

### BACKGROUND ART

Dielectrics are applied to various elements in the electronics field, such as piezoelectric elements, infrared sensors, optical modulators, memory elements or the like. With the development of the micro-machining technology and the demand for various kinds of smaller and lighter equipment, various kinds of thin film devices using these dielectric materials are coming into practical use in thin film technology and fine processing technology.

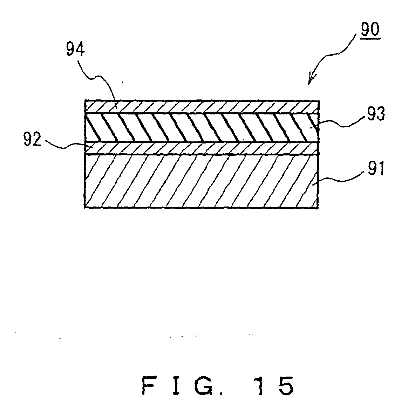

FIG. 15 shows an example of a configuration of a conventional dielectric thin film element (see I. Kanno et. al: Appl. Phys. Let. 70 (1997) p1378-1380). As shown in FIG. 15, this dielectric thin film element has a structure in which a lower electrode film 92 made of platinum (Pt) serving as a first electrode, a piezoelectric dielectric thin film 93 made of lead zirconate titanate (Pb(Zr,Ti)O₃) (hereinafter, referred to as "PZT"), and an upper electrode film 94 made of platinum (Pt) serving as a second electrode are formed in that order on a single crystal substrate 91 made of magnesium oxide (MgO). This dielectric thin film element may be used as, for example, an actuator, a pressure sensor, or an acceleration sensor by processing the single crystal substrate 91 etc.

Usually, crystal parameters such as crystal plane and lattice constant of dielectric thin films are affected considerably by the substrate on which the dielectric thin film is formed. For example, it is reported that the ferroelectric substance lead titanate (PbTiO₃) is oriented in (001) plane when formed on a single crystal substrate of magnesium oxide (MgO) that was cut out in such a manner that its (100) plane appears at the surface, and it is oriented in (111) plane when formed on a c-plane ((0001) plane) sapphire (Al₂O₃) substrate. This is because lead titanate (PbTiO₃) is affected considerably by the crystal plane of the substrate on which the lead titanate is formed. Furthermore, if the substrate that is used to form the dielectric thin film is a single crystal substrate, and if there is a large difference between the lattice constants of the substrate and the dielectric thin film, this also affects the orientation of the crystal plane. In addition, the internal stress in the dielectric thin film formed changes depending on the thermal expansion coefficient of the substrate regardless of the kind of the substrate, that is, regardless whether it is an oxide single crystal, a metal, or a glass substrate, and thus the crystal parameters such as the lattice constant will change.

In general, when the crystal parameters of the dielectric thin film change, the film characteristics, such as the electric characteristics (e.g., relative dielectric constant, coercive field, spontaneous polarization, piezoelectric constant, pyroelectric coefficient) and the optical characteristics (e.g., refractive index, electro-optic coefficient) will change considerably.

Also in the configuration of the conventional dielectric thin film element shown in FIG. 15, it is possible to change the film characteristics of the dielectric thin film, though to a small degree, by changing the fabrication conditions during the thin film formation.

However, the change in the film characteristics of the dielectric thin film that can be obtained with the conventional configuration as shown in FIG. 15 is smaller than that in the case where the thermal expansion coefficient of the substrate is changed considerably.

Moreover, when the substrate that is used to form the dielectric thin film is a single crystal substrate, the crystal orientation plane of the dielectric thin film is greatly dependent on the substrate and it is difficult to freely control its orientation, so that it is also difficult to change the film characteristics considerably.

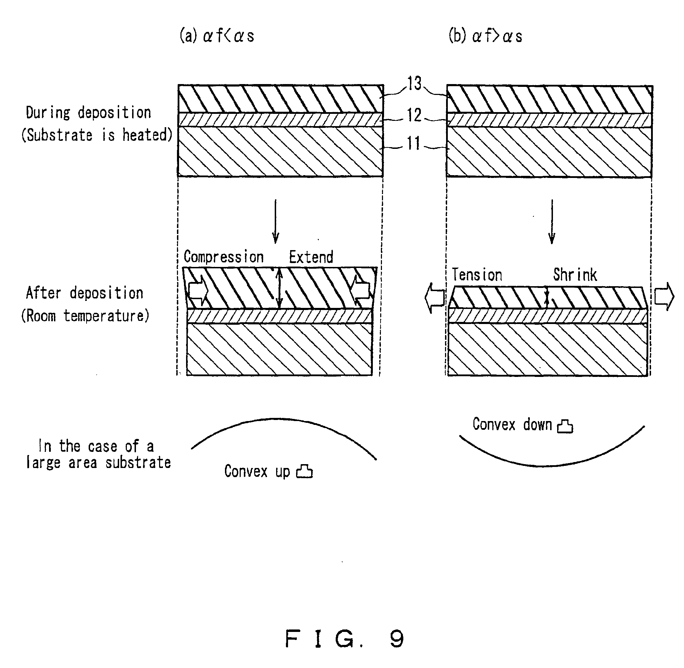

In addition, when there is a big difference in magnitude between the thermal expansion coefficient of the dielectric thin film that is formed and the thermal expansion coefficient of the substrate supporting the dielectric thin film, a large compressive or tensile stress is applied to the formed dielectric thin film, and accordingly the dielectric thin film element may warp convexly upward or convexly downward (see FIG. 9). Thus, when forming elements with a large surface area, work efficiency and operability in the processes of forming an element pattern by fine processing using photolithography, bonding after the processing, cutting and the like are poor.

### DISCLOSURE OF INVENTION

Therefore, with the foregoing in mind, it is an object of the present invention to provide, with good production yield, a dielectric thin film element having optimum film characteristics as well as an actuator, an ink jet head and an ink jet recording apparatus using the same.

In order to achieve the object, a first configuration of a dielectric thin film element according to the present invention includes a substrate, a first electrode formed on the substrate, a dielectric thin film formed on the first electrode and a second electrode formed on the dielectric thin film, and is fabricated with the substrate being heated. A material having a predetermined thermal expansion coefficient is used as the material of the substrate, and a crystal orientation of the dielectric thin film is controlled by the thermal expansion coefficient of the substrate.

According to this first configuration of the dielectric thin film element, it is possible to realize a dielectric thin film element whose characteristics such as electric characteristics are optimized, by using a material having an optimum thermal expansion coefficient as the material of the substrate for supporting the dielectric thin film.

It is preferable in the first configuration of the dielectric thin film element of the present invention that an intermediate layer is provided between the substrate and the first electrode. According to this preferred example, by arranging an intermediate layer having a predetermined orientation regardless of the kind of the substrate, the dielectric thin film having an optimum crystal orientation reflecting the orientation of the intermediate layer can be obtained, so that it is possible to realize a dielectric thin film element whose characteristics such as the electric characteristics are further optimized. In this case, it is preferable to use an oxide film having a rock-salt crystal structure as the intermediate layer. Furthermore, in this case, it is preferable that the oxide film having the rock-salt crystal structure has a (100) plane orientation, a (111) plane orientation, or a (110) plane orientation. Furthermore, in this case, it is preferable that the oxide film having the rock-salt crystal structure is a film of at least one selected from a group consisting of magnesium oxide (MgO), nickel oxide (NiO), cobalt oxide (CoO) and manganese oxide (MnO). Moreover, in this case, it is preferable to use an oxide film having a spinel crystal structure as the intermediate layer.

It is preferable in the first configuration of the dielectric thin film element of the present invention that at least one selected from a group consisting of platinum (Pt), palladium (Pd), iridium (Ir), gold (Au), iridium oxide (IrO₂), ruthenium oxide (RuO₂) and conductive nickel oxide (NiO) is used as a first electrode material.

A second configuration of the dielectric thin film element according to the present invention includes a substrate, a first electrode formed on the substrate, a dielectric thin film formed on the first electrode and a second electrode formed on the dielectric thin film, and is fabricated with the substrate being heated. When the thermal expansion coefficient of a material of the dielectric thin film is αf and the thermal expansion coefficient of a material of the substrate is αs, then the relationship 0.8 ≤ αf/αs ≤ 1.2 is satisfied.

According to this second configuration of the dielectric thin film element, the amount of the overall warping of the element is negligible, so that work efficiency and operability in the processes of forming an element pattern by fine processing using photolithography, bonding after the processing, dicing and the like can be improved.

It is preferable in the second configuration of the dielectric thin film element of the present invention that when the thickness of the dielectric thin film is tf and the thickness of the substrate is ts, the relationships 0.2 µm ≤ tf ≤ 10 µm and 0.15 mm ≤ ts ≤ 1.5 mm are satisfied. According to this preferred example, the amount of the overall warping of the element is even less noticeable, so that the work efficiency and operability can be improved further.

It is preferable in the second configuration of the dielectric thin film element of the present invention that the dielectric thin film material is a piezoelectric dielectric thin film material, and the relationship αf/αs > 1 is satisfied. According to this preferred example, it is possible to realize a dielectric thin film element having even better piezoelectric characteristics.

It is preferable in the second configuration of the dielectric thin film element of the present invention that the dielectric thin film material is a pyroelectric dielectric thin film material, and the relationship αf/αs < 1 is satisfied. According to this preferred example, it is possible to realize a dielectric thin film element having even better pyloelectric characteristics.

It is preferable in the second configuration of the dielectric thin film element of the present invention that the dielectric thin film material includes at least lead (Pb) and titanium (Ti).

It is preferable in the second configuration of the dielectric thin film element of the present invention that an intermediate layer is provided between the substrate and the first electrode. In this case, it is preferable to use an oxide film having a rock-salt crystal structure as the intermediate layer. Furthermore, in this case, it is preferable that the oxide film having the rock-salt crystal structure has a (100) plane orientation, a (111) plane orientation, or a (110) plane orientation. Furthermore, in this case, it is preferable that the oxide film having the rock-salt crystal structure is a film of at least one selected from the group consisting of magnesium oxide (MgO), nickel oxide (NiO), cobalt oxide (CoO) and manganese oxide (MnO). Moreover, in this case, it is preferable to use an oxide film having a spinel crystal structure as the intermediate layer.

It is preferable in the second configuration of the dielectric thin film element of the present invention that at least one selected from the group consisting of platinum (Pt), palladium (Pd), iridium (Ir), gold (Au), iridium oxide (IrO₂), ruthenium oxide (RuO₂) and conductive nickel oxide (NiO) is used as a first electrode material.

An actuator according to the present invention uses the piezoelectric dielectric thin film element of the present invention.

An ink jet head according to the present invention includes an actuator, a diaphragm on which the actuator is secured, a plurality of pressure chambers accommodating an ink liquid on which the displacement of the actuator acts via the diaphragm, and the actuator of the present invention is used as the actuator.

An ink jet recording apparatus according to the present invention includes an ink jet head and a recording medium transport means for transporting a recording medium in the direction approximately perpendicular to the cross direction of the ink jet head, and the ink jet head of the present invention is used as the ink jet head.

It is possible to control the performance of the dielectric thin film element constituting the actuator by selecting the material of a pressure chamber component, which is formed by processing the substrate, in consideration of its thermal expansion coefficient. In particular, when the thermal expansion coefficient of a material constituting the actuator (dielectric thin film material) is αf and the thermal expansion coefficient of the material of the pressure chamber component is αs, if the material constituting the actuator and the material of the pressure chamber component are selected such that the relationship 0.8 ≤ αf/αs ≤ 1.2 is satisfied, then it is possible to realize a large area ink jet head that enables high-speed and high-density printing, in which a number of nozzle holes are arranged with high density.

### BRIEF DESCRIPTION OF DRAWINGS

FIG. 1 is a cross-sectional view showing a dielectric thin film element in a first embodiment of the present invention;
FIG. 2 is a diagram showing an X-ray diffraction pattern of the dielectric thin film in the first embodiment of the present invention;
FIG. 3 is a diagram showing a relationship between a thermal expansion coefficient of a substrate and a diffraction angle 2θ at a (111) plane of the dielectric thin film formed on the substrate of the dielectric thin film element in the first embodiment of the present invention;
FIG. 4 is a diagram showing a relationship between the thermal expansion coefficient of the substrate and a relative dielectric constant of the dielectric thin film formed on the substrate, which has a (111) plane orientation, of the dielectric thin film element in the first embodiment of the present invention;
FIG. 5 is a cross-sectional view showing a dielectric thin film element in a second embodiment of the present invention;
FIG. 6 is a diagram showing an X-ray diffraction pattern of the dielectric thin film in the second embodiment of the present invention;
FIG. 7 is a diagram showing a relationship between a thermal expansion coefficient of a substrate and a diffraction angle 2θ at a (002) plane of the dielectric thin film formed on the substrate of the dielectric thin film element in the second embodiment of the present invention;
FIG. 8 is a diagram showing a relationship between the thermal expansion coefficient of the substrate and a relative dielectric constant of the dielectric thin film formed on the substrate, which has a (001) plane orientation or a (100) plane orientation, of the dielectric thin film element in the second embodiment of the present invention;
FIG. 9 shows diagrams illustrating a mechanism of changes in crystal parameters depending on the thermal expansion coefficient of the dielectric thin film material and warped states of the dielectric thin film element in the embodiments of the present invention;
FIG. 10 is a diagram showing a relationship between a thermal expansion coefficient of a substrate and a relative dielectric constant of a pyroelectric dielectric thin film (PLT dielectric thin film) formed on the substrate of the dielectric thin film element in a third embodiment of the present invention;
FIG. 11 is a diagram showing a relationship between a thermal expansion coefficient of a substrate and a pyroelectric coefficient γ of a pyroelectric dielectric thin film (PLT dielectric thin film) formed on the substrate of the dielectric thin film element in the third embodiment of the present invention;
FIG. 12 is a schematic perspective view showing the overall configuration of an ink jet recording apparatus in a fourth embodiment of the present invention;
FIG. 13 is a schematic perspective view showing the overall configuration of an ink jet head in the fourth embodiment of the present invention;
FIG. 14 is a partially cutaway exploded perspective view showing a relevant part of the ink jet head in the fourth embodiment of the present invention; and
FIG. 15 is a cross-sectional view showing a conventional dielectric thin film element.

### BEST MODE FOR CARRYING OUT THE INVENTION

Hereinafter, the present invention will be described more specifically by means of the following embodiments.

### First Embodiment

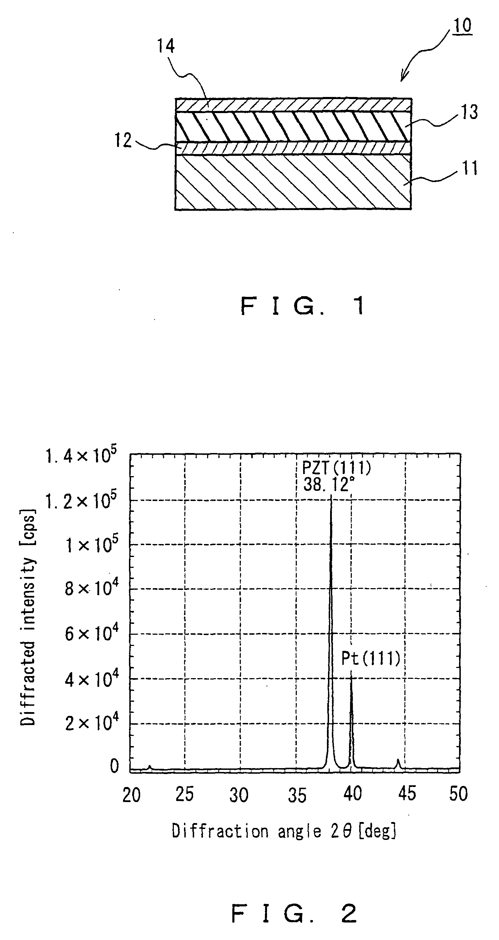

FIG. 1 is a cross-sectional view showing a dielectric thin film element in a first embodiment of the present invention.

In FIG. 1, numeral 10 denotes a dielectric thin film element. This dielectric thin film element 10 has a structure in which a lower electrode film made of platinum (Pt) serving as a first electrode 12, a lead zirconate titanate (PbZr_{0.53}Ti_{0.47}O₃) (hereinafter, referred to as "PZT") film (thermal expansion coefficient: about 60 × 10⁻⁷/K) serving as a dielectric thin film 13, and an upper electrode film made of chromium (Cr) serving as a second electrode 14 are formed in that order on a substrate 11. Various kinds of substrates with different thermal expansion coefficients as shown below (Table 1) are used for the substrate 11.

**Table 1**

| substrate material | thermal expansion coefficient (× 10⁻⁷/K) |
|---|---|
| quartz | 5.6 |
| silicon | 27 |
| 7059 glass | 46 |
| alumina | 68 |
| 860 crystallized glass | 108 |
| 863 crystallized glass | 142 |
| SUS304 | 173 |

The above dielectric thin film element 10 was fabricated in the following manner.

First, for example, a quartz substrate was placed in a vacuum vessel as the substrate 11. After evacuation, the substrate 11 was heated and maintained at a temperature of 600°C, and a lower electrode film (Pt electrode film) having a film thickness of 250 nm and made of platinum (Pt) was formed as the first electrode 12 on the substrate 11 by RF magnetron sputtering using a 4-inch Pt target. In this case, the sputtering was performed for 10 minutes using argon (Ar) as a sputtering gas, maintaining the gas pressure at 1 Pa and applying a high-frequency power of 100 W.

Next, the substrate temperature was set to 580°C, and the dielectric thin film (PZT dielectric thin film) 14 having a film thickness of 4 µm and made of PZT was formed on the first electrode 12 by RF magnetron sputtering using a 6-inch PZT sintered compact target (with 20 mol% lead oxide (PbO) excess). In this case, the sputtering was performed for 200 minutes using a mixed gas of argon (Ar) and oxygen (O₂) (at a gas ratio of Ar : O₂ = 19 : 1) as the sputtering gas, maintaining the gas pressure at 0.4 Pa and applying a high-frequency power of 500 W.

Then, without heating the substrate, an upper electrode film (Cr electrode film) having a film thickness of 10 nm and made of chromium (Cr) was formed as the second electrode 14 on the PZT dielectric thin film 14 by DC sputtering using a 4-inch Cr target. In this case, the sputtering was performed for 5 minutes using argon (Ar) as the sputtering gas, maintaining the gas pressure at 0.7 Pa and applying a power of 100 W.

FIG. 2 shows an X-ray diffraction pattern of the PZT dielectric thin film 14 formed on the above quartz substrate via the Pt electrode film (first electrode 12). This assessment was made at the stage before forming the second electrode 14. It was found that, as shown in FIG. 2, as the Pt electrode film serving as the first electrode 12 showed (111) plane orientation, the PZT dielectric thin film 14 also showed (111) plane orientation. The diffraction angle 2θ showing a peak of the (111) plane of the PZT dielectric thin film 14 was 38.12°.

The crystal orientation of the PZT dielectric thin film 14 is mainly the (111) plane orientation even when it is formed using the other substrates as shown above (Table 1) instead of the quartz substrate.

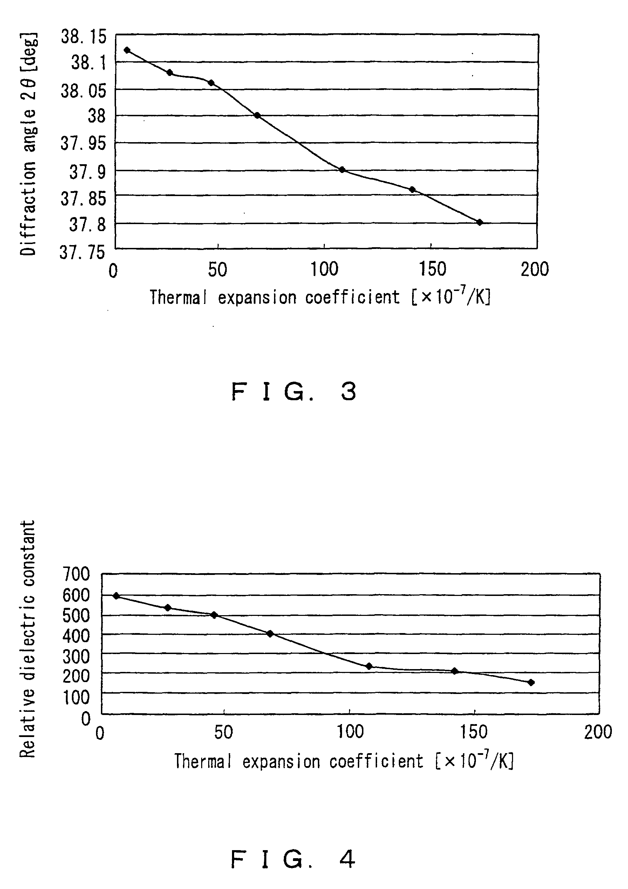

PZT dielectric thin films were formed in the same manner as described above, using the various kinds of substrates with different thermal expansion coefficients as shown above (Table 1), and the relationship between the thermal expansion coefficient of the substrate and the diffraction angle 2θ at the (111) plane of the formed PZT dielectric thin film was examined. FIG. 3 shows the results. As shown in FIG. 3, the larger the thermal expansion coefficient of the substrate is, the smaller is the diffraction angle at the (111) plane of the formed PZT dielectric thin film (and the larger is the lattice constant). This fact indicates that the lattice constant of the PZT dielectric thin film depends on the thermal expansion coefficient of the substrate.

This fact can be illustrated by means of FIG. 9 as follows. When the thermal expansion coefficient of the dielectric thin film material is αf and the thermal expansion coefficient of the substrate is αs, if αf < αs, then the shrinkage of the substrate is larger than that of the dielectric thin film when they reach room temperature after the deposition, as shown in FIG. 9(a). Influenced by the substrate, which has a larger volume, a compressive stress acts on the dielectric thin film and accordingly the lattice constant in the film thickness direction increases at the micro level. On the other hand, if αf> αs, then conversely, the shrinkage of the dielectric thin film is larger than that of the substrate when they reach room temperature after the deposition, as shown in FIG. 9(b). However, influenced by the substrate whose shrinkage is smaller, a tensile stress acts on the dielectric thin film and accordingly the lattice constant in the film thickness direction decreases at the micro level.

Moreover, dielectric thin film elements were fabricated in the same manner as described above, using the various kinds of substrates with different thermal expansion coefficients as shown above (Table 1), and the relationship between the thermal expansion coefficient of the substrate and the relative dielectric constant of the formed PZT dielectric thin film was examined. FIG. 4 shows the results. As shown in FIG. 4, the larger the thermal expansion coefficient of the substrate is, the smaller is the relative dielectric constant of the formed PZT dielectric thin film.

Based on the foregoing circumstances, it is possible to control the crystal orientation of the dielectric thin film that is formed and accordingly change the film characteristics such as the electric characteristics (e.g., relative dielectric constant, coercive field, spontaneous polarization, piezoelectric constant, pyroelectric coefficient) and the optical characteristics (e.g., refractive index, electro-optic coefficient) by changing the thermal expansion coefficient of the substrate, that is, by using substrates with different thermal expansion coefficients. Therefore, it is possible to realize a dielectric thin film element whose characteristics, such as its electric characteristics, are optimized, by using a material having an optimum thermal expansion coefficient as the material of the substrate for supporting the dielectric thin film.

Also when palladium (Pd), iridium (Ir), gold (Au), iridium oxide (IrO₂), ruthenium oxide (RuO₂) or conductive nickel oxide (NiO) was used instead of platinum (Pt) as the material of the first electrode 12 or when a combination of two or more of these was used, the same result was obtained, namely that the diffraction angle of the crystal orientation plane and the relative dielectric constant of the dielectric thin film 13 could be changed without damaging its characteristics by changing the thermal expansion coefficient of the substrate used.

To supply large numbers of the dielectric thin film elements as described above at low prices, it is possible to use a substrate having a large area as one solution. In this case, if the dielectric thin film element warps convexly upward or convexly downward (see FIG. 9), the work efficiency and operability are poor in the processes of forming an element pattern by fine processing using photolithography, bonding after the processing, dicing and the like. However, it was found that, in the configuration of the present invention, when the thermal expansion coefficient of the dielectric thin film material was αf and the thermal expansion coefficient of the substrate was αs, if the relationship 0.8 ≤ αf/αs ≤1.2 was satisfied, then the amount of the overall warping of the element was negligible, so that the work efficiency and operability in the processes of forming an element pattern by fine processing using photolithography, bonding after the processing, dicing and the like could be improved.

Moreover, it was found that, in this case, when the thickness of the dielectric thin film was tf and the thickness of the substrate was ts, if the relationships 0.2 µm ≤ tf ≤ 10 µm and 0.15 mm ≤ ts ≤ 1.5 mm were satisfied, then the amount of the overall warping of the element was even less noticeable, so that the work efficiency and operability could be improved further.

### Second Embodiment

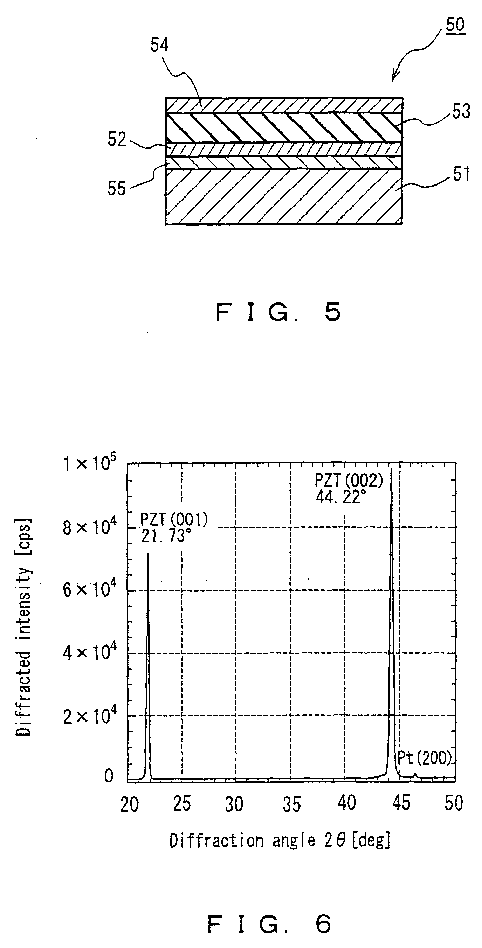

FIG. 5 is a cross-sectional view showing a dielectric thin film element in a second embodiment of the present invention.

In FIG. 5, numeral 50 denotes a dielectric thin film element. This dielectric thin film element 50 has a structure in which an oxide film having a rock-salt crystal structure, such as a magnesium oxide (MgO) film, serving as an intermediate layer 55, a lower electrode film made of platinum (Pt) serving as a first electrode 52, a lead zirconate titanate (PbZr_{0.53}Ti_{0.47}O₃) (hereinafter, referred to as "PZT") film (thermal expansion coefficient: about 60 × 10⁻⁷/K) serving as a dielectric thin film 53 and an upper electrode film made of chromium (Cr) serving as a second electrode 54 are formed in that order on a substrate 51. For the substrate 51, the various kinds of substrates with different thermal expansion coefficients as shown above (Table 1) are used as in the first embodiment.

The above dielectric thin film element 50 was fabricated in the following manner.

First, for example, a Corning 7059 glass substrate was placed in a vacuum vessel as the substrate 51. After evacuation, the substrate 51 was heated and maintained at a temperature of 400°C, and the intermediate layer 55 having a film thickness of about 700 nm and made of a MgO film having a rock-salt crystal structure with a (100) plane crystalline orientation was formed on the substrate 51 by plasma MOCVD. In this case, magnesium acetylacetonate (Mg(C₅H₇O₂)₂) vaporized at a temperature of 215°C was used as a raw material gas for CVD and introduced into the vacuum vessel together with a carrier gas of inert nitrogen (N₂), and at the same time, an oxygen (O₂) gas was introduced as a reactant gas. The flow ratio of the introduced gases was N₂ : O₂ = 250 (sccm) : 500 (sccm), and the film formation was performed while maintaining the gas pressure at 30 Pa and applying a high-frequency power of 400 W.

Next, the substrate 51 on which the intermediate layer 55 had been formed was placed in another vacuum vessel. After evaporation, the substrate 51 was heated and maintained at a temperature of 600°C, and the lower electrode film (Pt electrode film) having a film thickness of 250 nm and made of platinum (Pt) was formed as the first electrode 52 on the intermediate layer 55 by RF magnetron sputtering using the 4-inch Pt target. In this case, the sputtering was performed for 10 minutes using argon (Ar) as the sputtering gas, maintaining the gas pressure at 1 Pa, and applying a high-frequency power of 100 W.

Then, the substrate temperature was set to 580 °C, and the dielectric thin film (PZT dielectric thin film) 53 having a film thickness of 4 µm and made of PZT was formed on the first electrode 52 by RF magnetron sputtering using the 6-inch PZT sintered compact target (with 20 mol% lead oxide (PbO) excess). In this case, the sputtering was performed for 200 minutes using a mixed gas of argon (Ar) and oxygen (O₂) (at a gas ratio of Ar : O₂ = 19 : 1) as the sputtering gas, maintaining the gas pressure at 0.4 Pa and applying a high-frequency power of 500 W.

Then, without heating the substrate, the upper electrode film (Cr electrode film) having a film thickness of 10 nm and made of chromium (Cr) was formed as the second electrode 54 on the PZT dielectric thin film 53 by DC sputtering using the 4-inch Cr target. In this case, the sputtering was performed for 5 minutes using argon (Ar) as the sputtering gas, maintaining the gas pressure at 0.7 Pa and applying a power of 100 W.

FIG. 6 shows an X-ray diffraction pattern of the PZT dielectric thin film 53 formed on the above Corning 7059 glass substrate via the MgO film (intermediate layer 55) having the (100) plane orientation and the Pt electrode film (first electrode 52). This assessment was made at the stage before forming the second electrode 54. It was found that, as shown in FIG. 6, as the Pt electrode film serving as the first electrode 52 showed (100) plane orientation, the PZT dielectric thin film 53 showed (001) plane orientation. The diffraction angles 2θ showing the peaks of a (001) plane and a (002) plane of the PZT dielectric thin film 53 were 21.73° and 44.22°, respectively.

The crystal orientation of the PZT dielectric thin film 53 that is formed via the MgO film (intermediate layer 55) is mainly the (001) plane orientation even when it is formed using the other substrates as shown above (Table 1) instead of the Corning 7059 glass substrate.

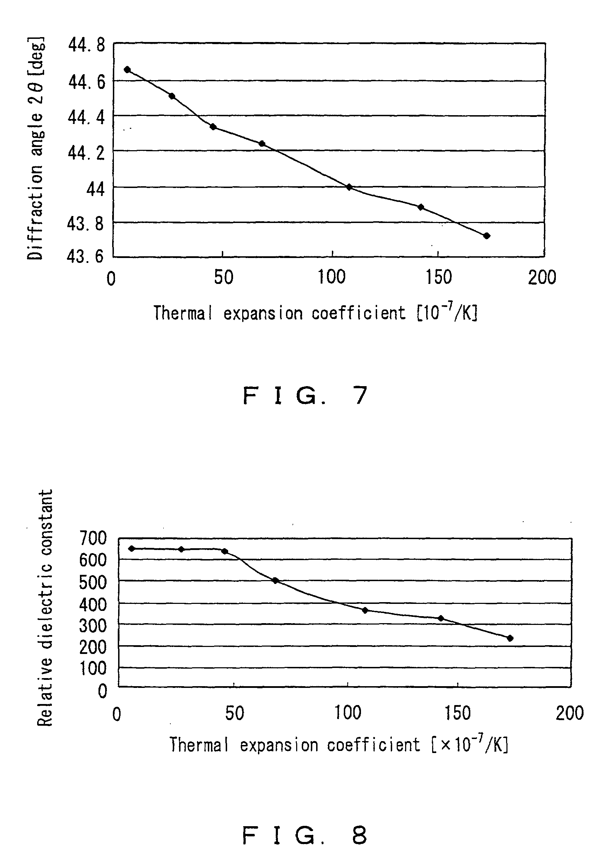

PZT dielectric thin films were formed in the same manner as described above, using the various kinds of substrates with different thermal expansion coefficients as shown above (Table 1), and the relationship between the thermal expansion coefficient of the substrate and the diffraction angle 2θ at the (002) plane of the formed PZT dielectric thin film was examined. FIG. 7 shows the results. As shown in FIG. 7, the larger the thermal expansion coefficient of the substrate is, the smaller is the diffraction angle at the (002) plane of the formed PZT dielectric thin film (and the larger is the lattice constant). This fact indicates that, as in the first embodiment, the lattice constant of the PZT dielectric thin film depends on the thermal expansion coefficient of the substrate.

This fact also can be illustrated by means of the mechanism shown in FIG. 9 as in the first embodiment.

Moreover, dielectric thin film elements were fabricated in the same manner as described above, using the various kinds of substrates with different thermal expansion coefficients as shown above (Table 1), and the relationship between the thermal expansion coefficient of the substrate and the relative dielectric constant of the formed PZT dielectric thin film was examined. FIG. 8 shows the results. As shown in FIG. 8, the larger the thermal expansion coefficient of the substrate is, the smaller is the relative dielectric constant of the formed PZT dielectric thin film, as in the first embodiment.

Based on the foregoing circumstances, it is possible to control the crystal orientation of the dielectric thin film that is formed and accordingly change the film characteristics such as the electric characteristics (e.g., relative dielectric constant, coercive field, spontaneous polarization, piezoelectric constant, pyroelectric coefficient) and the optical characteristics (e.g., refractive index, electro-optic coefficient) by changing the thermal expansion coefficient of the substrate, that is, by using substrates with different thermal expansion coefficients.

Moreover, it was found that also when an oxide having a rock-salt crystal structure other than magnesium oxide (MgO), such as nickel oxide (NiO), cobalt oxide (CoO) or manganese oxide (MnO), was used as the material of the intermediate layer 55 or when a combination of two or more of them was used, the crystal parameters such as the lattice constant and the film characteristics such as the relative dielectric constant of the dielectric thin film with respect to the thermal expansion coefficient of the substrate showed exactly the same tendencies in the configuration of the present invention.

Furthermore, it was found that when the oxide film having the rock-salt crystal structure used as the intermediate layer 55 showed (111) plane orientation or (110) plane orientation, the formed PZT dielectric thin film also showed (111) plane orientation or (110) plane orientation, respectively, and the crystal parameters such as the lattice constant and the film characteristics such as the relative dielectric constant of the dielectric thin film with respect to the thermal expansion coefficient of the substrate showed exactly the same tendencies.

Furthermore, it was found that also when an oxide having a spinel crystal structure such as magnesium aluminate (MgAl₂O₄) was used as the material of the intermediate layer 55, then the crystal parameters such as the lattice constant and the film characteristics such as the relative dielectric constant of the dielectric thin film with respect to the thermal expansion coefficient of the substrate showed exactly the same tendencies.

In addition, also when palladium (Pd), iridium (Ir), gold (Au), iridium oxide (IrO₂), ruthenium oxide (RuO₂) or conductive nickel oxide (NiO) was used instead of platinum (Pt) as the material of the first electrode 52 formed on the intermediate layer 55 or when a combination of two or more of them was used, then the characteristics of the dielectric thin film 53 were not compromised and the dependence of the crystal parameters and the film characteristics such as the relative dielectric constant on the thermal expansion coefficient of the substrate showed exactly the same tendencies.

Also in this embodiment, if the thickness of the intermediate layer is negligible compared to that of the substrate and, when the thermal expansion coefficient of the dielectric thin film material is αf and the thermal expansion coefficient of the substrate is αs, if the relationship 0.8 ≤ αf/αs ≤ 1.2 is satisfied, then the amount of the overall warping of the element is negligible, so that the work efficiency and operability in the processes of forming an element pattern by fine processing using photolithography, bonding after the processing, dicing and the like can be improved. Therefore, large numbers of dielectric thin film elements can be produced at low prices by using a substrate having a large surface area.

Moreover, it was found that, also in this embodiment, when the thickness of the dielectric thin film was tf and the thickness of the substrate was ts, if the relationships 0.2 µm ≤ tf ≤ 10 µm and 0.15 mm ≤ ts ≤ 1.5 mm were satisfied, the amount of the overall warping of the element was even less noticeable.

### Third Embodiment

In this embodiment, a dielectric thin film element using other pyroelectric dielectric materials of the present invention but having the same configuration as in the second embodiment will be described with reference to FIG. 5.

As shown in FIG. 5, a pyroelectric dielectric thin film element 50 of this embodiment has a structure in which an oxide film having a rock-salt crystal structure, such as a magnesium oxide (MgO) film, serving as an intermediate layer 55, a lower electrode film made of platinum (Pt) serving as a first electrode 52, a lead lanthanum titanate (Pb_{0.9}La_{0.1}Ti_{0.975}O₃) (hereinafter, referred to as "PLT") film (thermal expansion coefficient: about 30 × 10⁻⁷K) serving as a dielectric thin film 53 and an upper electrode film made of nichrome (NiCr) serving as a second electrode 54 are formed in that order on a substrate 51. As in the second embodiment, the various kinds of substrates with different thermal expansion coefficients as shown above (Table 1) are used for the substrate 51.

The above pyroelectric dielectric thin film element 50 was fabricated in the following manner.

First, for example, a SUS304 substrate was placed in a vacuum vessel as the substrate 51. After evacuation, the substrate 51 was heated and maintained at a temperature of 400°C as in the second embodiment 2, and the intermediate layer 55 having a film thickness of about 700 nm and made of the MgO film having the rock-salt crystal structure with the (100) plane crystalline orientation was formed on the substrate 51 by plasma MOCVD. In this case, a magnesium acetylacetonate gas (Mg(C₅H₇O₂)₂) vaporized at a temperature of 215°C was used as the raw material gas for CVD and introduced into the vacuum vessel together with the carrier gas of inert nitrogen (N₂), and at the same time, oxygen (O₂) gas was introduced as the reactant gas. The flow ratio of the introduced gases was N₂ : O₂ = 250 (sccm) : 500 (sccm), and the film formation was performed while maintaining the gas pressure at 30 Pa and applying a high-frequency power of 400 W.

Next, the substrate 51 on which the intermediate layer 55 had been formed was placed in another vacuum vessel. After evacuation, the substrate 51 was heated and maintained at a temperature of 600°C, and the lower electrode film (Pt electrode film) having a film thickness of 250 nm and made of platinum (Pt) was formed as the first electrode 52 on the intermediate layer 55 by RF magnetron sputtering using the 4-inch Pt target. In this case, the sputtering was performed for 10 minutes using argon (Ar) as the sputtering gas, maintaining the gas pressure at 1 Pa and applying a high-frequency power of 100 W.

Then, the substrate temperature was set to 560°C, and the dielectric thin film (PLT dielectric thin film) 53 having a film thickness of 3 µm and made of PLT was formed on the first electrode 52 by RF magnetron sputtering using a 6-inch PLT sintered compact target (with 20 mol% lead oxide (PbO) excess). In this case, the sputtering was performed for 180 minutes using a mixed gas of argon (Ar) and oxygen (O₂) (at a gas ratio of Ar : O₂ = 19:1) as the sputtering gas, maintaining the gas pressure at 0.35 Pa and applying a high-frequency power of 350 W.

Then, without heating the substrate, the upper electrode film (NiCr electrode film) having a film thickness of 10 nm and made of nichrome (NiCr) was formed as the second electrode 54 on the PLT dielectric thin film 53 by DC sputtering using a 4-inch NiCr target. In this case, the sputtering was performed for 5 minutes using argon (Ar) as the sputtering gas, maintaining the gas pressure at 0.7 Pa and applying a power of 100 W.

The crystal orientation of the PLT dielectric thin film 53 that is formed via the MgO film (intermediate layer 55) is mainly a (001) plane orientation even when it is formed using the other substrates as shown above (Table 1) instead of the SUS304 substrate.

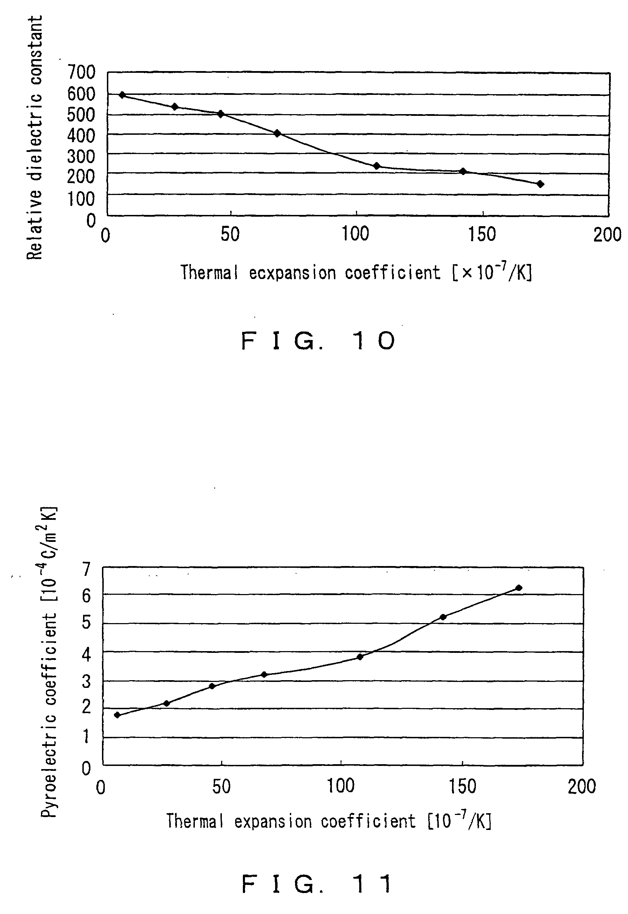

Pyroelectric dielectric thin film elements were fabricated in the same manner as described above, using the various kinds of substrates with different thermal expansion coefficients as shown above (Table 1), and the relationship between the thermal expansion coefficient of the substrate and the relative dielectric constant of the formed PLT dielectric thin film was examined. FIG. 10 shows the results. As shown in FIG. 10, the larger the thermal expansion coefficient of the substrate is, the smaller is the relative dielectric constant of the formed PLT dielectric thin film, as in the second embodiment.

Moreover, pyroelectric dielectric thin film elements were fabricated in the same manner as described above, using the various kinds of substrates with different thermal expansion coefficients as shown above (Table 1), and the relationship between the thermal expansion coefficient of the substrate and the pyroelectric coefficient γ determined from a pyroelectric current obtained by changing the temperature of the PLT dielectric thin film was examined. FIG. 11 shows the results. As shown in FIG. 11, the larger the thermal expansion coefficient of the substrate is, the larger is the pyroelectric coefficient γ of the PLT dielectric thin film. When the pyroelectric dielectric thin film element is used as a pyroelectric infrared sensor, the pyroelectric performance can be represented in a simple manner by the ratio γ/ε of the pyroelectric coefficient γ to the relative dielectric constant ε. Therefore, based on the above results, it can be seen that the higher the thermal expansion coefficient of the used substrate is, the better is the performance of the pyroelectric infrared sensor. That is to say, when the thermal expansion coefficient of the dielectric thin film material is αf and the thermal expansion coefficient of the substrate is αs, if the relationship αf/αs < 1 is satisfied, it is possible to realize a pyroelectric dielectric thin film element having a good performance.

Moreover, it was found that also when an oxide having a rock-salt crystal structure other than magnesium oxide (MgO), such as nickel oxide (NiO), cobalt oxide (CoO) or manganese oxide (MnO), was used as the material of the intermediate layer 55 or when a combination of two or more of them was used, then the film characteristics such as the relative dielectric constant and the pyroelectric performance of the dielectric thin film with respect to the thermal expansion coefficient of the substrate showed exactly the same tendencies in the configuration of the present invention.

Furthermore, it was found that when the oxide film having the rock-salt crystal structure used as the intermediate layer 55 had the (111) plane orientation or the (110) plane orientation, then the formed PLT dielectric thin film also showed the (111) plane orientation or the (110) plane orientation, respectively, and the film characteristics such as the relative dielectric constant and the pyroelectric performance of the dielectric thin film with respect to the thermal expansion coefficient of the substrate showed exactly the same tendencies.

Furthermore, it was found that also when an oxide having a spinel crystal structure such as magnesium aluminate (MgAl₂O₄) was used as the material of the intermediate layer 55, then the film characteristics such as the relative dielectric constant and the pyroelectric performance of the dielectric thin film with respect to the thermal expansion coefficient of the substrate showed exactly the same tendencies.

In addition, also when palladium (Pd), iridium (Ir), gold (Au), iridium oxide (IrO₂), ruthenium oxide (RuO₂) or conductive nickel oxide (NiO) was used instead of platinum (Pt) as the material of the first electrode 52 formed on the intermediate layer 55 or when a combination of two or more of them was used, then the characteristics of the dielectric thin film 53 were not compromised and the dependence of the film characteristics, such as the relative dielectric constant and the pyroelectric performance, on the thermal expansion coefficient of the substrate showed exactly the same tendencies.

Also in this embodiment, if the thickness of the intermediate layer is negligible compared to that of the substrate and, when the thermal expansion coefficient of the dielectric thin film material is αf and the thermal expansion coefficient of the substrate is αs, if the relationship 0.8 ≤ αf/αs ≤ 1.2 is satisfied, the amount of the overall warping of the element is negligible, so that the work efficiency and operability in the processes of forming an element pattern by fine processing using photolithography, bonding after the processing, dicing and the like can be improved. Therefore, large numbers of large area dielectric thin film elements such as dielectric thin film elements and infrared imaging elements can be produced at low prices by using a substrate having a large surface area.

Moreover, it was found that, also in his embodiment, when the thickness of the dielectric thin film was tf and the thickness of the substrate was ts, if the relationships 0.2 µm ≤ tf ≤ 10 µm and 0.15 mm ≤ ts ≤ 1.5 mm were satisfied, the amount of the overall warping of the element was even less noticeable.

### Fourth Embodiment

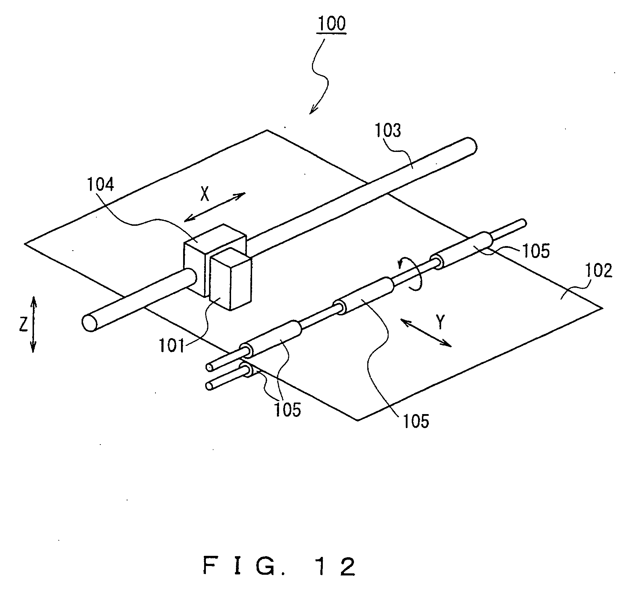

FIG. 12 is a schematic perspective view showing the overall configuration of an ink jet recording apparatus in a fourth embodiment of the present invention. As shown in FIG. 12, the ink jet recording apparatus 100 of this embodiment is provided with an ink jet head 101 for performing recordings by utilizing the piezoelectric effect of a piezoelectric dielectric thin film, and can perform the recordings on a recording medium 102 such as a paper by letting ink droplets ejected from the ink jet head 101 land on the recording medium 102. The ink jet head 101 is mounted on a carriage 104 that is slidably attached to a carriage shaft 103 arranged along the principal scanning direction (X direction in FIG. 12). The carriage 104 moves back and forth along the carriage shaft 103, and thus the ink jet head 101 moves back and forth in the principal scanning direction X. Furthermore, the ink jet recording apparatus 100 is provided with a plurality of rollers (recording medium transport means) 105 for moving the recording medium 102 in the secondary scanning direction Y, which is approximately perpendicular to the cross direction of the ink jet head 101 (i.e., principal scanning direction X).

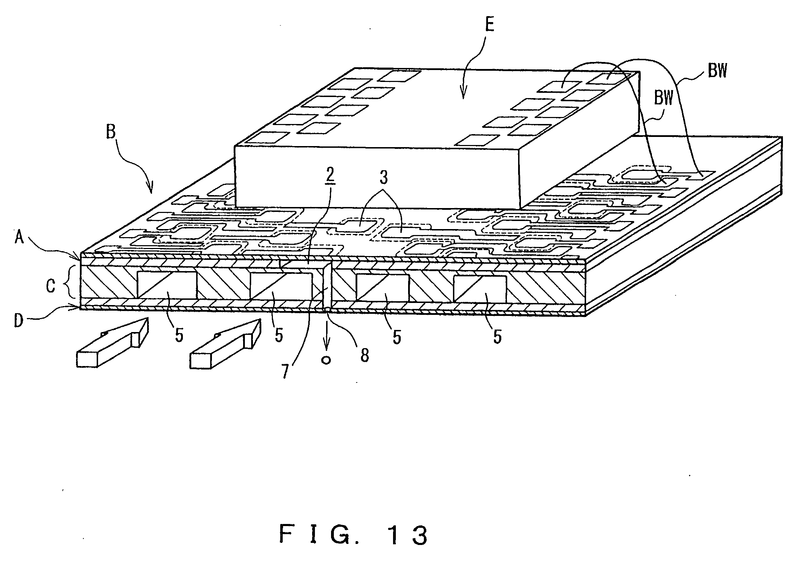

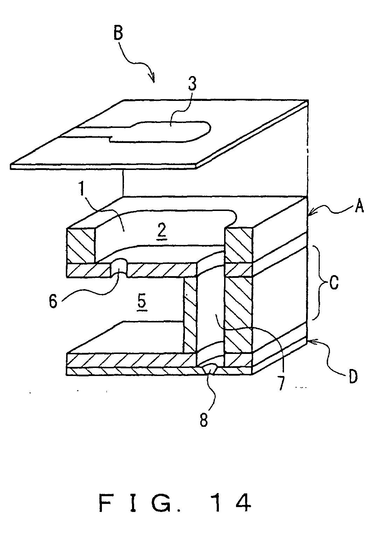

FIG. 13 is a schematic perspective view showing the overall configuration of the ink jet head in the fourth embodiment of the present invention and FIG. 14 is a partially cutaway exploded perspective view showing a configuration of its relevant part. In FIG. 13 and FIG. 14, letter A denotes a pressure chamber component that is formed by processing, for example, a silicon (Si) substrate, and a pressure chamber aperture portion 1 is formed in this pressure chamber component A. Letter B denotes an actuator constituted by the dielectric thin film element of the present invention that is arranged so as to cover the upper aperture side of the pressure chamber aperture portion 1, and letter C denotes an ink liquid passage component that is arranged so as to cover the lower aperture side of the pressure chamber aperture portion 1. That is to say, the pressure chamber aperture portion 1 of the pressure chamber component A is partitioned by the actuator B and the ink liquid passage component C that are positioned above and below thereof, and thus a pressure chamber 2 is formed. In the actuator B, an individual electrode 3 is arranged above the pressure chamber 2. As shown in FIG. 13, a number of pressure chambers 2 and individual electrodes 3 are arranged in a staggered pattern. Moreover, in the ink liquid passage component C, a common liquid chamber 5 that is shared by the pressure chambers 2, a supply port 6 for linking this common liquid chamber 5 with the pressure chamber 2, and an ink passage 7 through which the ink liquid within the pressure chamber 2 flows out are formed, aligned in the ink liquid supply direction. Letter D denotes a nozzle plate, and a nozzle hole 8 linked to the ink passage 7 is bored in this nozzle plate D. Moreover, in FIG. 13, letter E denotes an IC chip and this IC chip E supplies voltage to a plurality of individual electrodes 3 via bonding wires BW.

In this case, it is possible to control the performance of the dielectric thin film element constituting the actuator B by selecting the material of the pressure chamber component A, which is formed by processing the substrate, taking into account its thermal expansion coefficient. In particular, when the thermal expansion coefficient of the material constituting the actuator B (dielectric thin film material) is αf and the thermal expansion coefficient of the material of the pressure chamber component A is αs, if the material constituting the actuator B and the material of the pressure chamber component A are selected such that the relationship αf/αs > 1 is satisfied, then it is possible to realize an ink jet head having a dielectric thin film element with better piezoelectric characteristics (in this case, print characteristics). Furthermore, if the material constituting the actuator B and the material of the pressure chamber component A are selected such that the above αf and αs satisfy the relationship 0.8 ≤ αf/αs ≤ 1.2, then it is possible to realize a large area ink jet head that enables high-speed and high-density printing, in which a number of nozzle holes are arranged with high density.

### INDUSTRIAL APPLICABILITY

As described above, the present invention can provide a dielectric thin film element provided with a dielectric thin film whose film characteristics such as the relative dielectric constant can be changed considerably, by selecting a substrate material in consideration of the thermal expansion coefficient, so that it can be used for piezoelectric elements, infrared sensors, optical switches, memory elements and the like which require the element characteristics to be controlled and optimized with high yield rate.

## Claims

1. A dielectric thin film element comprising a substrate, a first electrode formed on the substrate, a dielectric thin film formed on the first electrode and a second electrode formed on the dielectric thin film, which is fabricated with the substrate being heated, wherein
a material having a predetermined thermal expansion coefficient is used as the material of the substrate, and
a crystal orientation of the dielectric thin film is controlled by the thermal expansion coefficient of the substrate.

2. The dielectric thin film element according to claim 1, wherein an intermediate layer is provided between the substrate and the first electrode.

3. A dielectric thin film element comprising a substrate, a first electrode formed on the substrate, a dielectric thin film formed on the first electrode and a second electrode formed on the dielectric thin film, which is fabricated with the substrate being heated, wherein
when a thermal expansion coefficient of a material of the dielectric thin film is αf and a thermal expansion coefficient of a material of the substrate is αs, then the relationship 0.8 ≤ αf/αs ≤ 1.2 is satisfied.

4. The dielectric thin film element according to claim 3, wherein
when a thickness of the dielectric thin film is tf and a thickness of the substrate is ts, then the relationships 0.2 µm ≤ tf ≤ 10 µm and 0.15 mm ≤ ts ≤ 1.5 mm are satisfied.

5. The dielectric thin film element according to claim 3, wherein
the dielectric thin film material is a piezoelectric dielectric thin film material, and
the relationship αf/αs > 1 is satisfied.

6. The dielectric thin film element according to claim 3, wherein
the dielectric thin film material is a pyroelectric dielectric thin film material, and
the relationship αf/αs < 1 is satisfied.

7. The dielectric thin film element according to claim 3, wherein the dielectric thin film material includes at least lead (Pb) and titanium (Ti).

8. The dielectric thin film element according to claim 3, wherein an intermediate layer is provided between the substrate and the first electrode.

9. The dielectric thin film element according to claim 2 or 8, using an oxide film having a rock-salt crystal structure as the intermediate layer.

10. The dielectric thin film element according to claim 9, wherein the oxide film having the rock-salt crystal structure has a (100) plane orientation, a (111) plane orientation, or a (110) plane orientation.

11. The dielectric thin film element according to claim 9, wherein the oxide film having the rock-salt crystal structure is a film of at least one selected from a group consisting of magnesium oxide (MgO), nickel oxide (NiO), cobalt oxide (CoO) and manganese oxide (MnO).

12. The dielectric thin film element according to claim 2 or 8, using an oxide film having a spinel crystal structure as the intermediate layer.

13. The dielectric thin film element according to claim 1 or 3, wherein at least one selected from a group consisting of platinum (Pt), palladium (Pd), iridium (Ir), gold (Au), iridium oxide (IrO₂), ruthenium oxide (RuO₂) and conductive nickel oxide (NiO) is used as a first electrode material.

14. An actuator using the dielectric thin film element according to any one of claims 1 to 5 or 7 to 13.

15. An ink jet head comprising an actuator, a diaphragm on which the actuator is secured, a plurality of pressure chambers accommodating an ink liquid on which a displacement of the actuator acts via the diaphragm, wherein the actuator according to claim 14 is used as the actuator.

16. An ink jet recording apparatus comprising an ink jet head and a recording medium transport means for transporting a recording medium in a direction approximately perpendicular to a cross direction of the ink jet head, wherein the ink jet head according to claim 15 is used as the ink jet head.
